# FASCICULE DE BREVET EUROPEEN

(11) **EP 2 139 305 B1**
(45) Date de publication et mention de la délivrance du brevet: **04.09.2013**
(21) Numéro de dépôt: 09305478.1
(22) Date de dépôt: 26.05.2009
(51) Int. Cl.: H05K 3/26, B08B 3/02, H05K 1/03, H05K 3/02, H05K 3/22

(54) **Procédé d'élimination de défaut de gravure d'une couche métallique déposée sur un support souple**
Verfahren zur Beseitigung von Gravierungsdefekten einer aufgetragenen Metallschicht
Method for eliminating engraving defects of a metallic layer deposited on a flexible support

(30) Priorité: 23.06.2008 FR 0854142
(43) Date de publication de la demande: 30.12.2009
(73) Titulaire: Commissariat à l'Énergie Atomique et aux Énergies Alternatives, 75015 Paris (FR)
(72) Inventeur: Bablet, Jacqueline, 38450, LE GUA (FR); Benwadih, Mohamed, 94500, CHAMPIGNY SUR MARNE (FR)
(74) Mandataire: Vuillermoz, Bruno

(56) Documents cités:
- JP-A- 2004 037 866
- US-A- 4 673 443
- US-A- 5 364 474
- US-A- 5 384 990
- US-A1- 2005 162 835
- GHANDOUR OSMAN ET AL.: PROCEEDINGS OF SPIE, vol. 4637, 2002, pages 90-101, XP002514093

## Description

### DOMAINE DE L'INVENTION

L'invention concerne l'élimination de défauts présents à la suite de la gravure par ablation laser d'une couche métallique déposée sur un support souple.

### ETAT DE LA TECHNIQUE

Pour créer des motifs métalliques à la surface d'un support souple, tel qu'un film plastique par exemple, il est connu de déposer sur celui-ci, par exemple par évaporation, une couche métallique d'une épaisseur d'une dizaine à une centaine de nanomètres, puis de graver la couche métallique déposée au moyen d'un faisceau laser à excimère présentant une longueur d'onde dans les ultraviolets entre 157 et 408 nanomètres, ledit faisceau pulsé étant projeté au travers d'un masque de verre et d'aluminium définissant les motifs à graver.

On observe cependant que ce type de gravure, plus communément désignée sous l'expression *« gravure par ablation laser par projection de masque* », produit sur les bords des motifs gravés des défauts nuisant à la qualité du composant final. En effet, les bords de gravure sont généralement accompagnés de bourrelets de métal en raison de la fusion de la couche métallique sous l'effet du laser, ou de décollements de métal formant des surplombs, ces décollements en surplomb portant usuellement le nom de *« casquettes* », ces surplombs pouvant mesurer de 200 nanomètres à 10 micromètres.

L'apparition de ces défauts est inhérente à la gravure par laser à excimère et s'explique par le fait que la chaleur des ultraviolets produits par le laser vaporise le support sur lequel est déposée la couche métallique, ce qui fait localement exploser cette dernière, et cela quelque soit le matériau métallique la composant.

Or, le composant gravé est généralement utilisé ultérieurement dans les composants microélectroniques et peut se voir recouvrir d'autres types de couches fonctionnelles, comme une couche mince de 100 nanomètres ou moins, telle qu'une couche de semiconducteur d'épaisseur comprise entre 30 et 70 nanomètres par exemple.

Le dépôt de couches sur une surface présentant des défauts de gravure du type bourrelets ou casquettes pose cependant de nombreux problèmes, comme par exemple des fuites électriques, des difficultés du passage de marche, des pertes de côte, un vieillissement prématuré, etc...

Pour pallier ces inconvénients, le document «Excimer ablation of ITO on flexible substrates for large format display applications », de Osman A. Ghandour et al., Photon Processing Microelectronics Photonics, SPIE, vol. 4637, pages 90-101, 2002, propose de projeter un jet de neige carbonique sur la surface gravée du composant.

Toutefois, on observe dans ce procédé de l'état de la technique que l'arrachement des casquettes est violent et peu maîtrisé, comme cela est visible à la figure 10, page 101 du document précité. Au final, la couche métallique finit par peler et le bord des gravures est détérioré.

### EXPOSE DE L'INVENTION

Le but de la présente invention est de résoudre le problème susmentionné en proposant un procédé d'élimination efficace des défauts de gravure, et plus particulièrement les casquettes, et qui ne dégrade pas les bords de gravure.

A cet effet, l'invention a pour objet un procédé d'élimination de défauts de gravure par ablation laser par projection de masque d'une couche métallique déposée sur un support souple, avantageusement réalisé en matière plastique, telle que le PEN (polyéthylène naphtalate), le PET (polyéthylène térephtalate), le polyimide.

On entend par substrat ou support souple, tout substrat apte à prendre des formes et à revenir dans sa position initiale. C'est en particulier le cas des matières plastiques, qui sont constituées de chaînes carbonées, et qui forment des films isolants après extrusion.

Selon l'invention, le procédé comporte la projection sur lesdits défauts d'un liquide sous une pression comprise entre 10,3 MPa et 20,7 MPa (1500 PSI et 3000 PSI).

En d'autres termes, les inventeurs se sont aperçus que la projection d'un liquide sous une pression correctement choisie a pour effet d'éliminer sensiblement l'ensemble des casquettes, tout en évitant les phénomènes de décollement et pelage de la couche métallique et de détérioration des bords de gravures.

On notera qu'une élimination efficace et sans détérioration, qui offre une reproductibilité accrue de la qualité de la surface gravée, permet d'éviter l'utilisation d'une couche sacrificielle sous et/ou sur la couche métallique devant être gravée mais aussi de réduire les énergies associées à l'ablation et donc de garantir une surface sous gravure de qualité, c'est-à-dire sans endommagement du support.

Selon un mode de réalisation particulier de l'invention, la projection est réalisée selon un angle supérieur ou égal à 30 ° avec la surface, et même sensiblement perpendiculairement à celle-ci. Dans ces conditions, toutes les casquettes, quelle que soit leur orientation, peuvent être éliminées.

Selon un mode de réalisation particulier de l'invention, le liquide est de l'eau désionisée.

En d'autres termes, le jet d'eau désionisée est chimiquement inoffensif pour la couche métallique, n'altère donc pas la surface de celle-ci, notamment sa rugosité. En outre, de par son mode de production, l'eau désionisée ne comporte pas de résidus et ne contamine donc pas le composant. Enfin, aucune charge n'est crée à la surface de celui-ci.

Si, de plus, la surface à préparer comporte des circuits électroniques, il est avantageux de réioniser cette eau désionisée pour éviter des phénomènes de charges électrostatiques sur les circuits, ce qui risque de les endommager. L'eau réionisée présente donc les avantages de l'eau ionisée associés à une caractéristique électrique

D'autres types de liquide sont possibles. De manière avantageuse, de l'alcool ou de l'acétone est utilisé lorsqu'un nettoyage de la surface du composant est en outre souhaité.

Selon un mode de réalisation particulier de l'invention, la projection de liquide est réalisée selon un mouvement rotatif et de va-et-vient relativement à la couche métallique.

Ainsi, la surface gravée est parcourue de manière efficace par le jet de liquide et les résidus sont balayés hors de celle-ci. En effet, la rotation associée à l'angle choisi permet d'attaquer les casquettes sous tous les angles, et ainsi les supprimer.

Selon un mode de réalisation particulier de l'invention, la pression du liquide est inférieure à 12,4 MPa (1800 PSI) lorsque la couche métallique a été déposée par évaporation sur le support souple.

En d'autres termes, un dépôt métallique par évaporation, selon la technique dite par « effet joule » ou par canon à électrons par exemple, induit une adhérence réduite de la couche métallique sur le support souple. L'utilisation d'une pression inférieure à 12,4 MPa (1800 PSI) mais supérieure à 10,3 MPa (1500 PSI) évite d'arracher les bords des motifs gravés tout en maintenant une élimination élevée des casquettes.

Pour des couches métalliques adhérant plus fortement au support souple, comme celle déposée par pulvérisation cathodique par exemple, une pression supérieure peut être utilisée afin d'augmenter l'efficacité de l'élimination des casquettes. En outre, le nombre de passages du jet de liquide haute pression peut être augmenté sans risque de détérioration des motifs gravés. Par exemple, le nombre de passages peut être triplé par rapport à des couches métalliques peu adhérentes.

On notera que l'épaisseur et la nature des matériaux de la couche métallique déposée (Cu, NiPd, Pt, Au ou autres) n'ont sensiblement pas d'influence sur l'efficacité de l'élimination, l'adhérence constituant le principal facteur influençant celle-ci.

Le procédé selon l'invention est par exemple mis en oeuvre par un équipement standard de nettoyage de particules utilisé dans le domaine de la microélectronique. Cet équipement comporte usuellement un support rotatif pour recevoir le composant à nettoyer, un bras articulé apte à effectuer des mouvements de va-et-vient et muni d'une buse d'un diamètre d'environ 30 micromètres. L'équipement comporte également un circuit de liquide sous pression alimentant la buse, celle-ci étant dirigée sensiblement perpendiculairement au composant à nettoyer. Lors d'un usage conventionnel d'un tel équipement, c'est à dire pour le nettoyage, la pression du liquide est de l'ordre de 8,3 à 10,3 MPa (1200 à 1500 PSI).

Selon l'invention, cet équipement de l'état de la technique est utilisé dans une autre gamme de pressions, à savoir pour fonctionner à des pressions de liquide comprises entre 10,3 MPa et 20,7 MPa (1500 PSI et environ 3000 PSI) avec une buse située à une distance d'un dizaine de millimètres de la surface du composant dont il faut éliminer les défauts.

## Revendications

1. Procédé d'élimination de défauts de gravure par ablation laser par projection de masque d'une couche métallique déposée sur un support souple, ***caractérisé* en ce qu'**il comporte la projection sur lesdits défauts d'un liquide sous une pression comprise entre (1500 PSI et 3000 PSI) 10,3 MPa et 20,7 MPa

2. Procédé selon la revendication 1, ***caractérisé* en ce que** la projection du liquide est réalisée selon un angle supérieur ou égal à 30 ° avec la couche métallique.

3. Procédé selon la revendication 2, ***caractérisé* en ce que** la projection du liquide est réalisée sensiblement perpendiculairement à la couche métallique.

4. Procédé selon l'une des revendications 1 à 3, ***caractérisé* en ce que** le liquide projeté est de l'eau désionisée.

5. Procédé selon la revendication 4, ***caractérisé* en ce que** l'eau désionisée est réionisée avant son utilisation.

6. Procédé selon l'une quelconque des revendications précédentes, ***caractérisé* en ce que** la projection de liquide est réalisée selon un mouvement rotatif et de va-et-vient relativement à la couche métallique.

7. Procédé selon l'une quelconque des revendications précédentes, ***caractérisé* en ce que** la pression du liquide est inférieure à 12,4 MPa (1800 PSI) lorsque la couche métallique a été déposée par évaporation sur le support souple.

8. Procédé selon l'une quelconque des revendications précédentes, ***caractérisé* en ce que** le support souple est réalisé en matière plastique.

9. Procédé selon la revendication 8, ***caractérisé* en ce que** le support souple est réalisé en un matériau choisi dans le groupe comprenant le PEN (polyéthylène naphtalate), le PET (polyéthylène térephtalate) et le polyimide.

## Patentansprüche

1. Verfahren zum Beseitigen von Lasergravurabtragungsfehlern durch Maskenprojektion einer Metallschicht, die auf einem flexiblen Träger abgeschieden ist, **dadurch gekennzeichnet, dass** es ein Aufspritzen einer Flüssigkeit unter einem Druck zwischen 10,3 MPa (1500 psi) und 20,7 MPa (3000 psi) auf die Fehler umfasst.

2. Verfahren nach Anspruch 1, **dadurch gekennzeichnet, dass** das Aufspritzen der Flüssigkeit in einem Winkel zur Metallschicht erfolgt, der größer als oder gleich 30° ist.

3. Verfahren nach Anspruch 2, **dadurch gekennzeichnet, dass** das Aufspritzen der Flüssigkeit im Wesentlichen senkrecht zur Metallschicht erfolgt.

4. Verfahren nach einem der Ansprüche 1 bis 3, **dadurch gekennzeichnet, dass** die aufgespritzte Flüssigkeit entionisiertes Wasser ist.

5. Verfahren nach Anspruch 4, **dadurch gekennzeichnet, dass** das entionisierte Wasser vor seinem Gebrauch wieder ionisiert wird.

6. Verfahren nach einem der vorhergehenden Ansprüche, **dadurch gekennzeichnet, dass** das Flüssigkeitsaufspritzen in einer Dreh- und Pendelbewegung in Bezug auf die Metallschicht erfolgt.

7. Verfahren nach einem der vorhergehenden Ansprüche, **dadurch gekennzeichnet, dass** der Druck der Flüssigkeit unter 12,4 MPa (1800 psi) liegt, wenn die Metallschicht durch Aufdampfen auf dem flexiblen Träger abgeschieden wurde.

8. Verfahren nach einem der vorhergehenden Ansprüche, **dadurch gekennzeichnet, dass** der flexible Träger aus Kunststoff besteht.

9. Verfahren nach Anspruch 8, **dadurch gekennzeichnet, dass** der flexible Träger aus einem Material besteht, das aus der Gruppe ausgewählt ist, die PEN (Polyethylennaphthalat), PET (Polyethylenterephthalat) und Polyimid umfasst.

## Claims

1. Method for eliminating mask projection laser ablation lithography defects from a metal film deposited on a flexible carrier, ***wherein*** it comprises the spraying onto said defects of a liquid pressurized at between 10,3 MPa and 20,7 MPa (1500 PSI and 3000 PSI).

2. Method as claimed in claim 1, ***wherein*** the liquid is sprayed at an angle above or equal to 30° with the metal film.

3. Method as claimed in claim 2, ***wherein*** the liquid is sprayed substantially perpendicular to the metal film.

4. Method as claimed on one of claims 1 to 3, ***wherein*** the sprayed liquid is de-ionized water.

5. Method as claimed in claim 4, ***wherein*** the de-ionized water is re-ionized before it is used.

6. Method as claimed in any one of the previous claims, ***wherein*** the liquid is sprayed in a rotary and reciprocating motion relative to the metal film.

7. Method as claimed in any one of the previous claims, ***wherein*** the liquid pressure is below 12,4 MPa (1800 PSI) when the metal film has been deposited by vapour deposition on the flexible carrier.

8. Method as claimed in any one of the previous claims, ***wherein*** the flexible carrier is made out of a plastic material.

9. Method as claimed in claim 8, ***wherein*** the flexible carrier is made out of a material selected from the group that includes PEN (polyethylene naphtalate), PET (polyethylene terephtalate) and polyimide.
